# FASCICULE DE BREVET EUROPEEN

(11) **EP 2 647 065 B1**
(45) Date de publication et mention de la délivrance du brevet: **04.03.2015**
(21) Numéro de dépôt: 11807711.4
(22) Date de dépôt: 05.12.2011
(51) Int. Cl.: H01L 51/10, H01L 51/00

(54) **POLYMERE COMPRENANT LOCALEMENT DES ZONES CONDUCTRICES**
Polymer mit leitenden Zonen an bestimmten Stellen
Polymer comprising locally conductive zones

(30) Priorité: 03.12.2010 FR 1004717
(43) Date de publication de la demande: 09.10.2013
(73) Titulaire: Commissariat à l'Énergie Atomique et aux Énergies Alternatives, 75015 Paris (FR)
(72) Inventeur: PHILIPPOT, Gilles, F-34270 Saint Jean de Cuculles (FR); CORONEL, Philippe, F-38530 Barraux (FR); BABLET, Jacqueline, F-38450 Le Gua (FR); BEMWADIH, Mohamed, F-94500 Champigny-sur-Marne (FR)
(74) Mandataire: Talbot, Alexandre
(86) Numéro de dépôt international: PCT/FR2011/000636
(87) Numéro de publication internationale: WO 2012/072900

(56) Documents cités:
- EP-A1- 2 011 844
- WO-A1-2009/128514
- WO-A2-2004/055920
- US-A- 3 248 474
- US-A1- 2004 075 155

## Description

### Domaine technique de l'invention

L'invention est relative à la formation de dispositifs dans une couche en matériau polymère, et plus particulièrement à la création de zones conductrices dans le matériau polymère.

### État de la technique

Dans le domaine de l'électronique organique, les dispositifs sont généralement formés dans des matériaux polymères. Bien que les polymères soient majoritairement isolants, il existe des polymères dits conjugués qui, à l'état dopé, conduisent l'électricité. Dans un état non-dopé, les polymères conjugués sont des matériaux semi-conducteurs. Ils sont alors utilisés comme couche active au sein de dispositifs tels que les diodes électroluminescentes organiques (OLED), les transistors à effet de champ organiques (OFET) ou encore les cellules photovoltaïques organiques.

Les matériaux polymères thermoplastiques sont généralement classés en deux catégories, amorphes et semi-cristallins. Un polymère amorphe présente une structure désordonnée, c'est-à-dire que les chaînes moléculaires du polymère sont entremêlées. Dans un polymère semi-cristallin, les chaînes sont localement ordonnées pour former des monocristaux. Ces monocristaux sont enrobés de matière amorphe. Ainsi, les polymères semi-cristallins sont caractérisés par leur taux de cristallinité.

On définit la température T_{G} de transition vitreuse comme étant la température à laquelle un matériau thermoplastique amorphe passe d'un état solide à un état caoutchouteux. En dessous de la température T_{G}, le matériau est à l'état solide, ou vitreux, et présente un comportement élastique. Au-dessus de T_{G}, les liaisons entre les chaînes moléculaires se fragilisent. Le matériau se ramollit et peut être déformé plastiquement.

Le phénomène de transition vitreuse s'applique également à un matériau thermoplastique semi-cristallin puisqu'il est en partie composé de matière amorphe. Un matériau semi-cristallin est en outre caractérisé par une température de fusion T_{M}, supérieure à T_{G}. Au-delà de la température de fusion, le matériau devient complètement amorphe. Les matériaux semi-cristallins sont donc généralement chauffés à une température comprise entre T_{G} et T_{M} pour conserver leur caractère cristallin.

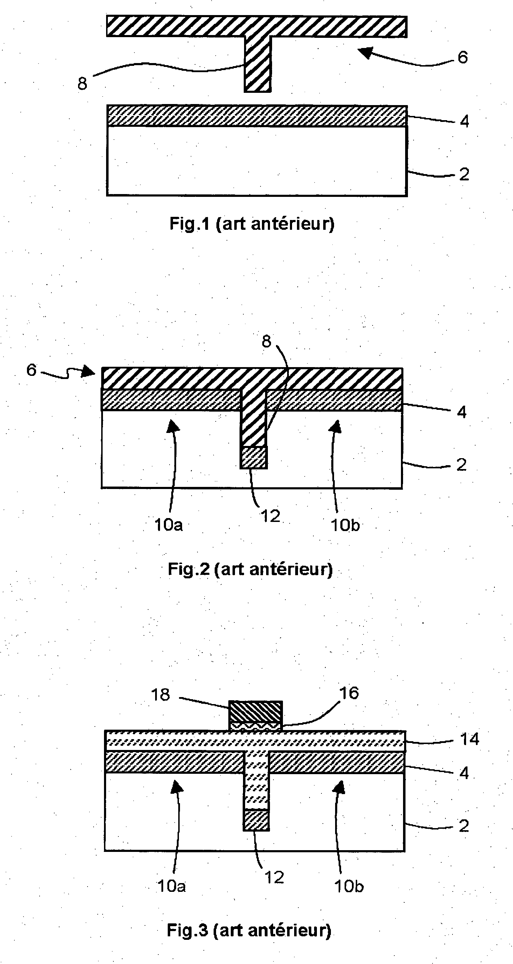

Les figures 1 à 3 représentent des étapes d'un procédé de réalisation d'un transistor organique en couches minces (TFT, « Thin-Film Transistor ») selon la demande de brevet US2004/0075155.

La figure 1 représente un substrat 2 en matériau polymère thermoplastique recouvert d'une piste 4 en matériau électriquement conducteur. Un outil 6 en métal, muni d'un poinçon 8, est chauffé à une température supérieure à la température de transition vitreuse du matériau thermoplastique 2. Le matériau 2 est également chauffé.

A la figure 2, l'outil 6 est pressé contre le substrat 2 au niveau de la piste 4. Le poinçon 8 s'enfonce dans le substrat 2, ce qui déforme le matériau thermoplastique et cisaille la piste conductrice 4. La piste 4 est divisée en deux parties, 10a et 10b, correspondant aux drain et source du transistor. Un fragment 12 de la piste 4 est enfoncé dans le substrat 2 par le poinçon 8.

Le matériau 2 est ensuite refroidi sous pression pour compenser le retrait du matériau 2 et ainsi maintenir les dimensions de la portion déformée.

La figure 3 représente une étape de finalisation du transistor, après avoir retiré l'outil 6 du substrat 2. Une couche 14 en matériau polymère semiconducteur est déposée sur la piste conductrice 4, au-dessus du drain 10a et de la source 10b, et dans la tranchée subsistant au-dessus du fragment 12, formant un canal entre le drain et la source. Un oxyde de grille 16 et une grille 18 sont ensuite déposés sur la couche 14 au-dessus du canal.

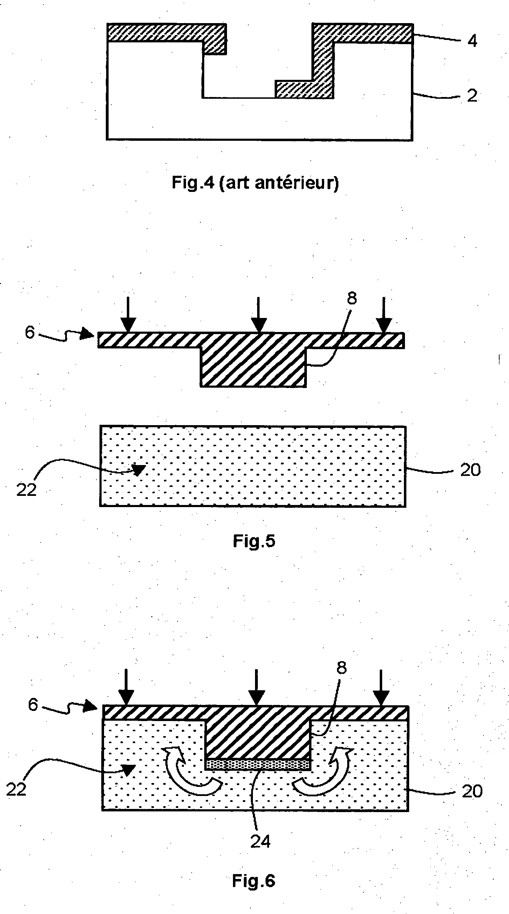

La figure 4 représente un exemple de piste conductrice 4 cisaillée selon la technique du document US2004/0075155. Dans certains cas, la découpe de la piste 4 est mal alignée par rapport à la portion emboutie du matériau 2, comme cela est représenté sur la figure 4. En effet, il est difficile de maîtriser la manière dont se cisaille la piste 4. La piste 4 peut même ne pas se cisailler et fluer en suivant le contour du poinçon.

Ainsi, cette technique ne permet pas de découper une couche conductrice de façon propre et symétrique pour définir les drain et source d'un transistor organique. Une telle imprécision est préjudiciable au fonctionnement du transistor.

Par ailleurs, le document US3248474 décrit la formation de zones conductrices sur un substrat formé de résine epoxy et de particules métalliques, en traçant un chemin sur la surface du substrat avec un instrument tranchant ou en perçant des trous dans le substrat.

### Résumé de l'invention

On constate qu'on a besoin d'un procédé précis et facile à mettre en oeuvre pour réaliser un dispositif comprenant des zones électriquement conductrices de dimensions maîtrisées sur une couche en matériau polymère électriquement isolant.

On tend à satisfaire ce besoin en prévoyant une couche en matériau polymère comprenant des particules conductrices selon une densité telle que la couche soit isolante, en portant le matériau polymère à une température supérieure ou égale à la température de transition vitreuse du matériau polymère, en comprimant une portion de la couche en matériau polymère à l'aide d'un poinçon de manière à obtenir une densité de particules conductrices telle que la portion devienne conductrice, et en retirant le poinçon de la couche en matériau polymère.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- les figures 1 à 3, précédemment décrites, représentent des étapes d'un procédé de formation d'un transistor organique selon l'art antérieur ;
- la figure 4, précédemment décrite, représente un exemple de découpe d'une piste conductrice sur un substrat en matériau plastique selon le procédé des figures 1 à 3 ;
- les figures 5 à 7 représentent des étapes d'un procédé de réalisation de zones conductrices dans un matériau polymère isolant selon l'invention ;
- les figures 8 à 10 représentent des variantes de mise en oeuvre de l'étape de compression de la figure 6 ;
- les figures 11A à 11C représentent des exemples de moule utilisé dans le procédé selon l'invention ; et
- la figure 12 représente un mode de réalisation d'un dispositif comprenant plusieurs zones conductrices obtenues par le procédé selon l'invention.

### Description d'un mode de réalisation préféré de l'invention

En observant le comportement d'un matériau polymère lorsqu'il est chauffé et comprimé avec un moule, on constate qu'une partie du matériau, disposée sous les parties saillantes du moule, est comprimée. La partie restante du matériau flue vers les zones creuses du moule.

On propose ici de mettre en application ce constat pour former un dispositif muni de zones électriquement conductrices. Pour cela, on utilise une couche en matériau polymère dans laquelle sont dispersées des particules électriquement conductrices. Initialement, la densité de particules est telle que la couche est isolante. En comprimant certaines zones du matériau polymère, on concentre les particules pour rendre ces zones conductrices.

Les figures 5 et 6 représentent des étapes d'un procédé de formation d'un dispositif à partir d'une couche en matériau polymère selon ce principe.

La figure 5 représente une couche 20 à base de matériau polymère, de préférence un polymère thermoplastique. La couche 20 comprend en outre des particules conductrices 22 dispersées dans le matériau polymère. Les particules sont, de préférence, dispersées de façon globalement homogène dans la couche 20. On pourrait néanmoins envisager des zones chargées de particules conductrices qui seront comprimées et des zones dépourvues de particules.

Les particules conductrices 22 sont, de préférence, des particules métalliques, par exemple en nickel, cuivre ou argent, des mélanges à base de métaux et de semi-conducteurs comme les siliciures (CoSi₂, NiSi) ou des particules de carbone (par exemple sous la forme de graphène ou de fullerène).

Une matrice 6 est agencée au-dessus de la couche 20. Elle comprend un poinçon 8 définissant un motif, dirigé vers la couche 20. De préférence, la matrice 6 est formée dans un matériau thermiquement conducteur, par exemple un métal ou du silicium, et chauffée à une température supérieure ou égale à la température de transition vitreuse du matériau polymère 20.

A la figure 6, la matrice 6 est pressée contre la couche 20. Le poinçon 8 s'enfonce dans la couche 20 et déforme le matériau polymère chargé de particules. Cette déformation est rendue possible par le chauffage du matériau 20, soit directement, soit pas l'intermédiaire de la matrice 6. Il en résulte une zone comprimée 24 localisée sous le poinçon 8. En d'autres termes, la partie complémentaire du motif formé dans la matrice est imprimée sur la couche 20.

L'étape de compression a une durée, de préférence, comprise entre 1 min et 60 min. La pression appliquée est, de préférence, comprise entre 1 MPa et 3 MPa. Lors de la compression, le matériau polymère 20 atteint une température supérieure ou égale à la température de transition vitreuse T_{G}. La température atteinte est de préférence, inférieure ou égale à la température de fusion T_{M} du polymère. La température du matériau 20 est, de préférence, de 50 °C à 90 °C supérieure à la température de transition vitreuse T_{G}.

Dans le cas d'un matériau 20 thermoplastique, les régions amorphes vont fluer sous l'action de la température et de la pression, comme cela est schématisé par les flèches pleines sur la figure 6. Par contre, les particules 22 sont concentrées dans la zone comprimée 24, ce qui rend la zone 24 électriquement conductrice. En effet, la distance entre les particules conductrices devient suffisamment faible pour qu'un courant électrique puisse traverser le matériau polymère. La résistivité électrique dans la zone 24 diminue alors significativement.

Dans la zone restante de la couche 20, la densité de particules ne varie pratiquement pas. En effet, le déplacement de particules 22 avec la matière amorphe est négligeable. Cette zone reste donc électriquement isolante. Par précaution, on pourra éloigner les motifs les uns des autres de manière à ce qu'ils soient bien séparés par une zone isolante.

On pourra en outre prévoir des zones en creux à proximité des zones à emboutir. Ces zones en creux pourront alors absorber le matériau repoussé lors de la compression.

On considère généralement qu'un matériau polymère est isolant lorsque sa résistivité est supérieure à 10⁴ Ω.cm et qu'un matériau est conducteur en dessous de 1 Ω.cm. Ainsi, la densité de particules dans la zone 24 est telle que la résistivité soit inférieure à 1 Ω.cm et la densité de particules dans la couche 20 restante est telle que la résistivité soit supérieure à 10⁴ Ω.cm.

De façon générale, la zone 24 devient conductrice lorsque la densité de particules est supérieure ou égale au seuil de percolation. Ce seuil dépend principalement des matériaux utilisés et de la taille des particules conductrices, et peut être exprimé en pourcentage du volume de particules dans le matériau polymère. Il est, de préférence, compris entre 1 % et 20 %. Il vaut, par exemple, environ 20 % quand les particules sont réparties de façon homogène et environ 1 % lorsque les particules ont été organisées au préalable, par exemple regroupées dans des plans parallèles à la surface à compresser.

Le matériau 20 est, de préférence, refroidi en maintenant la pression de la matrice 6 pour figer les dimensions du motif imprimé dans la couche 20.

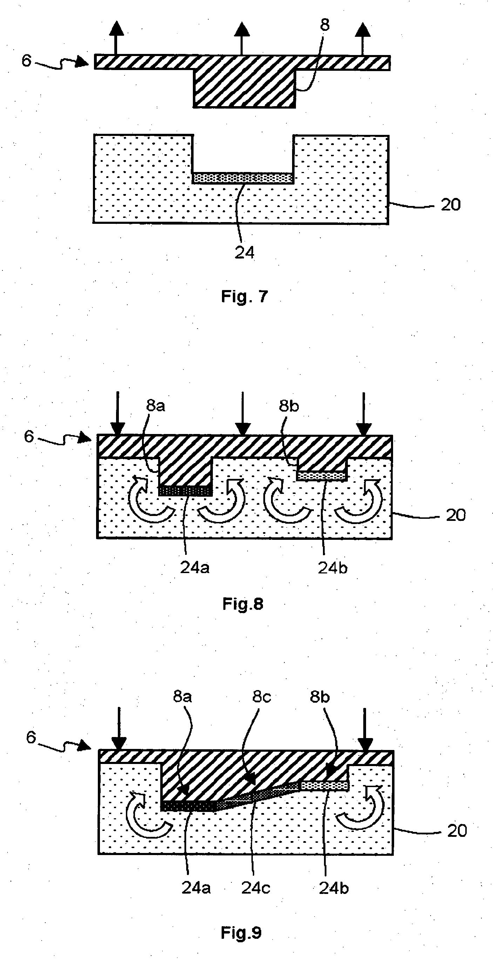

A l'étape de la figure 7, la matrice 6 et son poinçon 8 sont retirés de la couche 20 en matériau polymère. On obtient alors un dispositif muni d'une zone électriquement conductrice 24 enfoncée dans la couche polymère isolante.

Le procédé peut se poursuivre par des étapes de remplissage de la zone emboutie, par exemple par un matériau électriquement isolant ou semiconducteur, pour finaliser le dispositif. La zone conductrice 24 est alors enterrée.

Ainsi, ce procédé permet la formation d'un dispositif électronique, tel qu'un transistor à effet de champ. Dans ce cas, la zone conductrice 24 peut jouer le rôle d'électrode de grille du transistor. La couche isolante et la couche semi-conductrice déposées ultérieurement formeront respectivement l'oxyde de grille et le canal du transistor.

A titre d'exemple, une couche en polyéthylène naphtalate (PEN), de 125 µm d'épaisseur environ, est disposée sur un substrat de support en silicium. Le polyéthylène naphtalate est un matériau thermoplastique semi-cristallin ayant un taux de cristallinité de l'ordre de 45 %. Le taux de matière amorphe vaut donc 55 %, ce qui rend le matériau PEN compressible. La température de transition vitreuse du polyéthylène naphtalate est de 120 °C environ.

Des particules de nickel sont insérées dans la couche PEN. La quantité de particules représente environ 5 % du volume du matériau thermoplastique. La résistivité de la couche obtenue est environ égale à 10⁶ Ω.cm.

La matrice comprend des poinçons sous la forme de plots de section rectangulaire ayant une hauteur d'environ 20 µm.

Le substrat et la matrice sont placés dans une presse équipée de deux systèmes chauffants, l'un en contact avec la matrice et l'autre en contact avec le substrat de support. Le substrat et la matrice sont tous deux chauffés à une température de l'ordre de 190 °C.

La matrice est ensuite appliquée sur la couche en polyéthylène naphtalate pendant une durée approximative de 5 min, en maintenant la température à 190 °C et en exerçant une pression de l'ordre de 1,2 MPa.

Comme décrit précédemment, la matière amorphe des zones comprimées flue dans la couche pour remplir les cavités de la matrice (entre les plots) tandis que les monocristaux et les particules conductrices se concentrent dans les zones comprimées.

Dans les zones comprimées, la quantité de particules de nickel avoisine 20 % du volume de matériau PEN. La résistivité se situe en dessous de 1 Ω.cm. Les zones comprimées sont donc devenues conductrices.

La figure 8 représente une variante de mise en oeuvre dans laquelle la matrice 6 comprend deux poinçons 8a et 8b. Les poinçons 8a et 8b ont des hauteurs d'enfoncement dans la couche polymère différentes. Le poinçon 8a a par exemple une hauteur plus importante que le poinçon 8b. Lorsque la matrice est appliquée, on obtient deux zones conductrices 24a et 24b. La zone 24a correspondant au poinçon 8a a une conductivité électrique plus élevée que la zone 24b. Ainsi, en jouant sur les hauteurs des poinçons, on peut obtenir des zones sur différents niveaux et de conductivités différentes.

Dans le mode de mise en oeuvre de la figure 9, la matrice 6 comprend un poinçon ayant une hauteur d'enfoncement variable. Le poinçon comprend par exemple deux portions planes 8a et 8b, ayant des hauteurs d'enfoncement différentes (telles que les poinçons de la figure 8), et une portion intermédiaire 8c qui relie les portions 8a et 8b. De préférence, la portion 8c présente une hauteur d'enfoncement qui varie continûment entre la hauteur de la portion 8a et la hauteur de la portion 8b.

Après emboutissage, on obtient deux zones conductrices 24a et 24b, de conductivités différentes, reliées électriquement par une troisième zone conductrice 24c. Les zones 24a et 24b sont respectivement obtenues par la compression des portions 8a et 8b du poinçon, comme cela a été décrit en relation avec la figure 8. La zone 24c, qui résulte de la compression de la portion 8c, présente un gradient de conductivité électrique, du fait de la hauteur d'enfoncement variable de la portion 8c.

Dans l'exemple de la figure 9, le gradient de conductivité électrique de la zone 24c s'étend, de façon continue, de la conductivité de la zone 24a à la conductivité de la zone 24b.

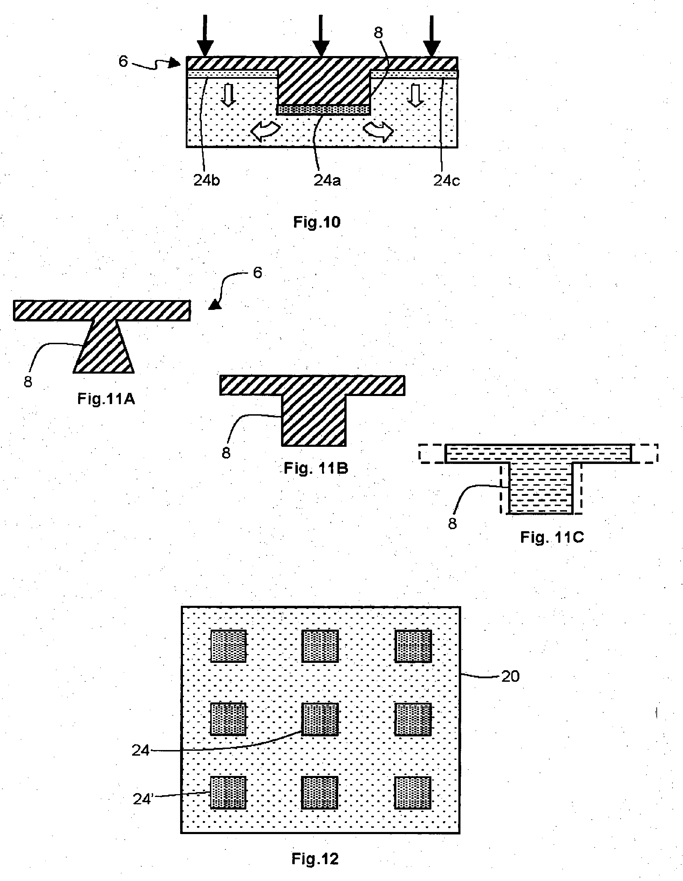

La figure 10 représente une autre variante de l'étape de la figure 6. En élevant la pression, on comprime également la face supérieure de la couche 20. La matière déplacée se répartit alors dans le volume de la couche 20. On peut par exemple définir de cette manière la grille 24a, le drain 24b et la source 24c d'un transistor dans une couche en matériau polymère.

Dans ce cas, c'est toute la matrice 6 qui sert de poinçon, c'est-à-dire qui sert à comprimer la couche en matériau polymère.

Les figures 11A à 11C représentent des exemples de réalisation d'une matrice 6. En choisissant la configuration de la matrice, il est possible de maîtriser le phénomène de concentration des particules. Dans l'exemple de la figure 11A où le poinçon a une base plus étroite que son sommet, la zone comprimée se situera essentiellement sous le poinçon 8. Par contre, dans le cas de la figure 11B où le poinçon est de section rectangulaire, on observe également une zone comprimée au niveau des faces latérales du poinçon 8 (non représentée sur les figures 6 à 10).

On peut également envisager une matrice munie d'un motif dont les dimensions varient lorsqu'on applique un courant électrique, un champ électrique, un champ magnétique ou une autre stimulation (Fig.11C). Une telle matrice est, de préférence, formée dans un matériau piézoélectrique, magnétostrictif, électrostrictif, un matériau à mémoire de forme ou un matériau de type électrolyte. Selon la nature et l'intensité de la stimulation, le poinçon 8 adopte une forme particulière. A titre d'exemple, si le poinçon 8 se déforme latéralement, on obtiendra une zone conductrice sur les côtés du motif imprimé dans la couche 20.

La figure 12 représente, en vue de dessus, un mode de réalisation de dispositif comprenant plusieurs zones conductrices 24, 24' dans une couche polymère 20 isolante. Une zone conductrice, par exemple la zone 24 située au centre de la figure 12, peut être supprimée en y appliquant une tension élevée ou un champ magnétique. On engendre ainsi une augmentation de la température, ce qui ramollit localement le matériau 20 et permet le déplacement des particules. L'agitation thermique éparpille les particules conductrices. La zone 24 redevient alors isolante.

Inversement, il est possible de rendre cette zone centrale 24 à nouveau conductrice en appliquant un champ électrique ou magnétique autour de la zone 24, par exemple par l'intermédiaire des zones périphériques 24', et en chauffant la zone centrale 24. Les particules mobiles se concentrent de nouveau dans la zone centrale.

Ainsi, en préparant un substrat en matière plastique chargé de particules conductrices et en le comprimant, on définit de façon simple et précise des zones conductrices directement dans le substrat. On s'affranchit ainsi d'une couche conductrice déposée sur le substrat et de la découpe d'une telle couche.

Un grand nombre de matériaux polymères peut désormais être utilisé pour former un dispositif électronique muni de zones conductrices. En effet, le choix ne se limite plus aux polymères conjugués qui sont habituellement dopés pour devenir conducteurs. En particulier, les élastomères peuvent être utilisés.

Le procédé décrit ci-dessus est plus simple que les techniques de dopage des polymères conjugués car il nécessite moins d'étapes technologiques. Par ailleurs, les zones dopées sont figées alors que les zones conductrices 24 obtenue par compression sont configurables à volonté.

## Revendications

1. Procédé de réalisation d'une zone électriquement conductrice dans un matériau polymère, comprenant les étapes suivantes :
- prévoir une couche (20) en matériau polymère comprenant des particules électriquement conductrices (22) selon une densité telle que la couche soit isolante,
- comprimer une portion (24, 24', 24a, 24b) de la couche (20) en matériau polymère à l'aide d'un poinçon (8) de manière à obtenir une densité de particules conductrices telle que ladite portion devienne conductrice, et
- retirer le poinçon de la couche (20) en matériau polymère,
**caractérisé en ce que** le matériau polymère est porté à une température supérieure ou égale à la température de transition vitreuse du matériau polymère, avant de comprimer la portion de la couche en matériau polymère.

2. Procédé selon la revendication 1, **caractérisé en ce que** la portion (24, 24', 24a, 24b) de la couche en matériau polymère est comprimée pendant une durée comprise entre 1 min et 60 min.

3. Procédé selon la revendication 1 ou 2, **caractérisé en ce que** la portion (24, 24', 24a, 24b) de la couche en matériau polymère est comprimée avec une pression comprise entre 1 MPa et 3 MPa.

4. Procédé selon l'une quelconque des revendications 1 à 3, **caractérisé en ce que** la couche (20) en matériau polymère est comprimée à l'aide de deux poinçons (8a, 8b) ayant des hauteurs d'enfoncement différentes, d'où il résulte deux zones électriquement conductrices ayant des conductivités électriques différentes.

5. Procédé selon l'une quelconque des revendications 1 à 3, caractérisé en que la couche (20) en matériau polymère est comprimée à l'aide d'un poinçon (8c) présentant une hauteur d'enfoncement variable, d'où il résulte une zone électriquement conductrice ayant un gradient de conductivité électrique.

6. Procédé selon la revendication 5, caractérisé en que la hauteur d'enfoncement du poinçon (8c) varie de façon continue.

## Patentansprüche

1. Verfahren zur Herstellung eines elektrisch leitenden Bereichs in einem Polymermaterial, umfassend die folgenden Schritte:
- Vorsehen einer Schicht (20) aus Polymermaterial, die elektrisch leitende Partikel (22) in einer Dichte, die derart ist, dass die Schicht isolierend ist, umfasst,
- Verdichten eines Abschnitts (24,24', 24a, 24b) der Schicht (20) aus Polymermaterial mit Hilfe eines Stempels (8), um eine Dichte von leitenden Partikeln zu erhalten, die derart ist, dass der Abschnitt leitend wird, und
- Herausziehen des Stempels aus der Schicht (20) aus Polymermaterial,
**dadurch gekennzeichnet, dass** das Polymermaterial auf eine Temperatur oberhalb oder gleich der Glasübergangstemperatur des Polymermaterial erhitzt wird, bevor der Abschnitt der Schicht aus Polymermaterial verdichtet wird.

2. Verfahren nach Anspruch 1, **dadurch gekennzeichnet, dass** der Abschnitt (24, 24', 24a, 24b) der Schicht aus Polymermaterial über eine Dauer zwischen 1 Min. und 60 Min. verdichtet wird.

3. Verfahren nach Anspruch 1 oder 2, **dadurch gekennzeichnet, dass** der Abschnitt (24, 24', 24a, 24b) der Schicht aus Polymermaterial mit einem Druck zwischen 1 MPa und 3 MPa verdichtet wird.

4. Verfahren nach einem der Ansprüche 1 bis 3, **dadurch gekennzeichnet, dass** die Schicht (20) aus Polymermaterial mit Hilfe von zwei Stempeln (8a, 8b), die unterschiedliche Eindringhöhen haben, verdichtet wird, woraus sich zwei elektrisch leistende Bereiche mit unterschiedlichen elektrischen Leitfähigkeiten ergeben.

5. Verfahren nach einem der Ansprüche 1 bis 3, **dadurch gekennzeichnet, dass** die Schicht (20) aus Polymermaterial mit Hilfe eines Stempels (8c), der eine variable Eindringhöhe aufweist, verdichtet wird, woraus sich ein elektrisch leitender Bereich mit einem Gradienten elektrischer Leitfähigkeit ergibt.

6. Verfahren nach Anspruch 5, **dadurch gekennzeichnet, dass** die Eindringhöhe des Stempels (8c) kontinuierlich variiert.

## Claims

1. Method for producing an electrically conductive area in a polymer material, comprising the following steps:
- providing a polymer layer (20) comprising electrically conductive particles (22) with a density such that the layer is insulating,
- heating the polymer material to a temperature higher than or equal to the glass transition temperature of the polymer material,
- compressing a portion (24, 24', 24a, 24b) of the polymer layer (20) by means of a stamp (8), in order to obtain a density of conductive particles such that said portion becomes conductive, and
- removing the stamp from the polymer layer (20),
**characterized in that** the polymer material is raised to a temperature higher than or equal to the glass transition temperature of the polymer material, before compressing of the portion of the polymer layer.

2. Method according to claim 1, **characterized in that** the portion (24, 24', 24a, 24b) of the polymer layer is compressed during a time comprised between 1 min and 60 min.

3. Method according to claim 1 or 2, **characterized in that** the portion (24, 24', 24a, 24b) of the polymer layer is compressed with a pressure comprised between 1 MPa and 3 MPa.

4. Method according to any one of claims 1 to 3, **characterized in that** the polymer layer (20) is compressed by means of two stamps (8a, 8b) having different depression heights, resulting in two electrically conductive areas having different electric conductivities.

5. Method according to any one of claims 1 to 3, **characterized in that** the polymer layer (20) is compressed by means of a stamp (8c) presenting a variable depression height, resulting in an electrically conductive area having an electric conductivity gradient.

6. Method according to claim 5, **characterized in that** the depression height of the stamp (8c) varies in continuous manner.
